# EUROPEAN PATENT SPECIFICATION

(11) **EP 1 704 761 B1**
(45) Date of publication and mention of the grant of the patent: **07.11.2007**
(21) Application number: 05707759.6
(22) Date of filing: 10.01.2005
(51) Int. Cl.: H05K 13/04

(54) **METHOD FOR GLUING A CIRCUIT COMPONENT TO A CIRCUIT BOARD**
VERFAHREN ZUM ANKLEBEN EINER SCHALTUNGSKOMPONENTE AN EINE LEITERPLATTE
PROCEDE PERMETTANT DE COLLER UN COMPOSANT DE CIRCUIT SUR UNE CARTE A CIRCUIT

(30) Priority: 16.01.2004 DE 102004002274
(43) Date of publication of application: 27.09.2006
(73) Proprietor: Ericsson AB, Stockholm (SE)
(72) Inventor: KONRATH, Willibald, 71554 Weissach im Tal (DE); SCHOLL, Klaus, 71522 Backnang (DE); SCHMELCHER, Haiko, 74427 Fichtenberg (DE); MULLER, Ulf, 71522 Backnang (DE)
(74) Representative: Stasiewski, Piotr Grzegorz
(86) International application number: PCT/EP2005/050084
(87) International publication number: WO 2005/069714

(56) References cited:
- WO-A-02/32201
- WO-A-20/04098258
- US-B1- 6 541 063

## Description

The present invention relates to a method for gluing a circuit component to a circuit board, which is applicable in automated assembly of electronic, optic or hybrid circuits.

For fixing circuit components to a circuit board, soldering and gluing methods are generally used. Soldering methods have the advantage that the connecting layer which holds circuit board and circuit component together is metallic and has a good heat conductivity, so that heat loss of the circuit components is efficiently carried off into the circuit board. However, soldering is intricate from the point of view of processing, since the circuit board must be heated with circuit components placed on it. Particularly when manufacturing high frequency circuits, the circuit board must be handled without any vibrations between placing and soldering, because a slippage of the circuit components might cause a change of signal delays between them and, hence, incontrollable phase shifts between the signals, which may affect the functionality of the circuit

Gluing methods are much simpler from the processing point of view, because in principle is sufficient to apply adhesive to the circuit component or the circuit board, to place the circuit component and, if necessary, to wait for the adhesive to cure. A disadvantage is that the heat conductivity of the adhesives, generally being based on an organic resin, is substantially lower than that of solder. In order to compensate this disadvantage, the adhesive layer between the circuit board and the circuit component must be made as thin as possible. For this, small quantities of adhesive must be metered. This may e.g. be done by applying dots of identical size in a regular pattern on a contact surface between the circuit board and a circuit component and then squeezing them between the circuit board and the circuit component, so that they merge into a continuous layer (see e.g. WO 02/32201 A1). The smaller the applied quantities of adhesive are, the higher is the risk that the adhesive will not wet the entire contact surface. Unwetted places form a barrier for the heat flow, which may cause the concerned circuit component to overheat and to be destroyed in operation.

In order to verify that the contact surface is wetted completely by the adhesive, every single contact surface must be examined by x-rays. This method requires expensive apparatus and is very laborious. Further, it only allows for quality enforcement a posteriori by sorting out workpieces which are not completely glued. It is not possible to prevent incomplete gluing in advance.

Another problem of the known gluing methods is that when defining positions and sizes of the drops of the regular pattern, care must be taken that when pressing the circuit component to the circuit board, the adhesive will spread up to the edges of the circuit component and even a little beyond, but that, on the other hand, the quantity of adhesive squeezed out at these edges must not be so large that a considerable quantity of it enters a gap between two adjacent circuit components and rises therein, e. g. by capillary action, between facing flanks of the circuit components. If this happens, the adhesive will affect the dielectric constant of the gap and, accordingly, propagation delays of signals in lines that span the gap. For the operability of a high frequency circuit, the consequences thereof would be the same as those of imprecise placing of the circuit components.

The consequence of this requirement is that the adhesive layer between circuit component and circuit board does often not expand into the corners of the contact surface. When pressure is applied to the circuit component at these corners, e. g. during wire bonding, this may cause the circuit component to break or pieces to splinter off.

The object of the present invention is therefore to provide a method for gluing a circuit component to a circuit board which yields an adhesive layer without voids at the contact surface between circuit component and circuit board with high reliability.

The object is achieved, on the one hand, by a method having the features of claim 1.

The method is based on the insight that when placing adhesive dots in a regular pattern, the first dots which are delivered by a dot-placing nozzle after an interruption of the placing operation tend to differ in volume from the dots delivered in continuous operation. Such a volume variation may already result from the fact that the delivery of adhesive by the nozzle is interrupted for the time the nozzle takes to move from the contact surface of one circuit component to the contact surface of the next one (see e.g. US 6541063 B1). By placing fore-running adhesive dots inside the contact surface before beginning to place the dots of the regular pattern, essentially two effects are achieved. On the one hand, the volume of the adhesive dots placed after placing the fore-running adhesive dots is stabilized, so that the dots of the regular pattern have a uniform volume; on the other hand, the fact that the density of the adhesive in the area of the fore-running dots is increased with respect to the rest of the regular pattern causes the merging of the adhesive dots the begin at the fore-running dots, when circuit component and circuit board are pressed against each other, and a void-free adhesive layer to expand continuously from the region surrounding the fore-running dots to the edges of the contact surface, air being expelled continuously from between circuit board and circuit component towards the edges of the contact surface, while circuit component and circuit board approach each other.

Preferably, plural fore-running adhesive dots are placed along a line, so that when these begin to merge with the adjacent dots of the regular pattern, no air can be trapped between the expanding continuous adhesive layers.

The amount of adhesive contained in the fore-running adhesive dots should be less than a tenth of the amount contained in the adhesive dots of the regular pattern.

In order to ensure that a void-free adhesive layer extends also below the corners of the circuit component, it is preferred to place an additional adhesive dot in the vicinity of each corner of the regular pattern. Such an additional adhesive dot may be placed before or after the regular pattern. Preferably it is placed on the bisectrix of a corner of the circuit component which corresponds to the corner of the regular pattern.

The distance of the additional adhesive dot from an adjacent edge from the circuit component is preferably less than the distance of the dot of the regular pattern from this edge.

The amount of adhesive employed is preferably calculated such that a thickness of the adhesive layer between the circuit board and the circuit component of approximately 2 to 10 µm, preferably about 5 µm is obtained, e. g. by defining the distance between dots of the regular pattern or the volume of these accordingly.

Preferably, epoxy resin loaded with metal particles, in particular with silver flakes, is used as an adhesive.

Further features and advantages of the invention become apparent from the subsequent description of an embodiment referring to the appended figures.
- Fig. 1: illustrates the placing of adhesive dots of a surface of a circuit board;
- Fig. 2: illustrates the placing of a circuit component on the circuit board; and
- Figs. 3A - 3D: show the development of the adhesive dots during the placing of the circuit component.

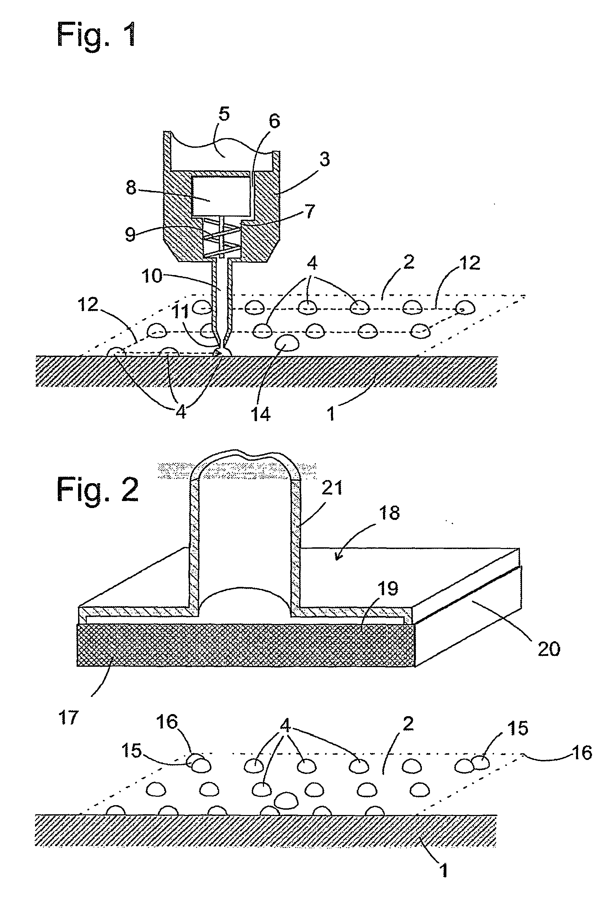

A circuit board 1 is shown in Fig. 1, partly in perspective, partly in section. On the upper side of circuit board 1, a contact surface 2 is highlighted by a dash-dot frame, which contact surface is intended for mounting a circuit component thereon.

A dispenser head 3, which is moved over the contact surface 2 in order to place adhesive dots 4 on it is also shown in section. The dispenser head 3 is displaceable along rails (not shown) above the circuit board both in the section plane of the fig. and in a plane perpendicular thereto. The upper region of the dispenser head 3 comprises an adhesive tank 5, not shown completely, from which a channel 6 leads to a chamber 7, in which a worm 9 rotatably driven by a motor 8 is located. From the bottom side of the dispenser head 3, a hollow needle 10 projects downward. The tip of the needle forms a nozzle 11 from which adhesive metered by the worm 9 emerges.

The dispenser head 3 is moved over the contact surface 2 along a meandering track 12 represented as a dashed line at a constant speed, while approaching the surface at regular time intervals in order to place an adhesive dot 13 thereupon. During this movement of the dispenser head 3, the worm 9 rotates continuously, so that the delivered adhesive quantity is the same for each dot 13. In this way, a regular pattern of dots arranged in rows and columns is obtained.

A dot 14, referred to as a fore-running adhesive dot has already been placed on the contact surface 2 before the dots 4. This dot 14 is slightly larger than the dots 4 of the regular pattern, because it contains not only the adhesive metered by the worm 9 at the time it was placed, but also adhesive which has gathered at nozzle 11 in a previous stationary phase of dispenser head 3. In this way, it is ensured that the first dot 4 of the regular pattern already has the same volume as the subsequent dots, so that the density distribution of the adhesive along the entire edge of the contact surface 2 is uniform and slightly less than in the centre of the contact surface 2.

After the regular pattern, the dispenser head 3 produces a number of additional dots 15 in the corners of the contact surface 2. These additional dots 15 are placed on the bisectrix of the corresponding corner 16 of the contact surface 2 or of the corresponding corner of a circuit component to be placed thereupon, respectively, so that when pressing the circuit component 17 (see Fig. 2) to the circuit board 1, the adhesive contained in them spreads in equal proportions towards both edges of the circuit component 17.

Fig. 2 shows the placing of the circuit component 17 on the contact surface 2 of the circuit board 1. The circuit component 17 is held by a gripper 18, which is displaceable above the circuit board in the same way as the dispenser head 3. The gripper 18 has an abutment surface 19, which is in contact with the upper side of circuit component 17. Incidentally, the abutment surface 19 is surrounded by a circumferential web 20, which is adapted to the dimensions of the circuit component 17 and is in contact with the lateral flanks thereof. A suction stub 21 issuing from abutment surface 19 has negative pressure applied to it by a suction pump, not shown, whereby the circuit component 17 is held fixed to the gripper 18.

From the position shown in Fig. 2, in which the edges of the circuit component 17 are aligned with those of the contact surface 2, the gripper 18 with the circuit component 17 is descended vertically, so that the circuit component comes into contact with the adhesive dots 13, 14, 15.

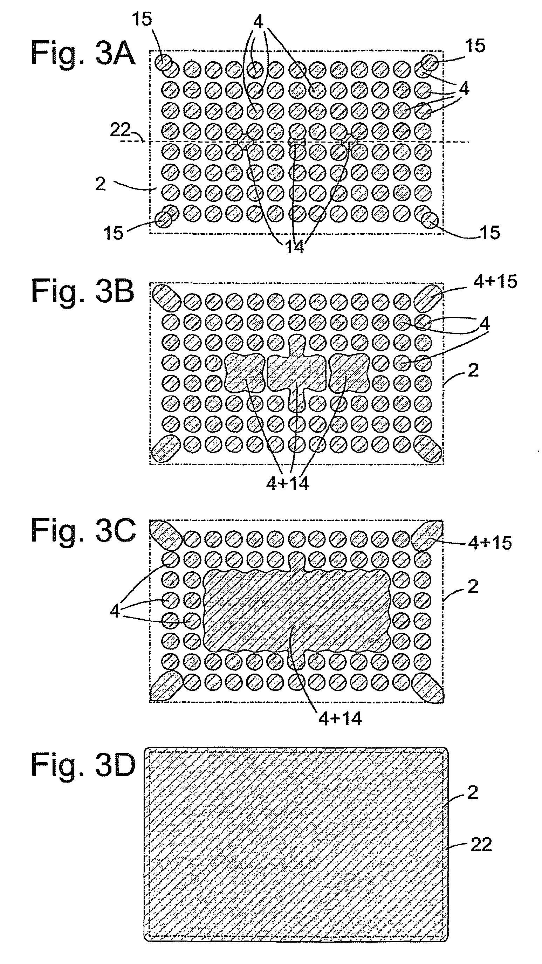

Fig. 3A shows the distribution of the adhesive on the contact surface 2 in a plan view, before coming into contact with the circuit component 17. The adhesive dots 4 form a rectangular pattern, in the present case having eight lines and thirteen columns. Along a central longitudinal axis 22 of the pattern, the fore-running dots 14 have been placed in advance. A central fore-running dot 14 is aligned with the dots 13 of the central column, the two outer fore-running dots 14 are placed centrally between four dots 13 of two different columns.

When it is begun to press the circuit component 17 against the circuit board 1 and thereby to squeeze the adhesive dots 4, 14, 15, the fore-running dots 14 are the first to begin to merge with adjacent dots 4 of the regular pattern and to spread, as shown in Fig. 3B. Larger continuous adhesive layers are thus formed first in the centre of the pattern and grow from there towards the edges while successively merging with dots 4 surrounding them. The placement of the fore-running dots 14 in the centre ensures that the growth of the continuous adhesive layer occurs from inside to outside; therefore a situation is prevented in which air cannot escape from the centre of the contact area because it is completely surrounded by merged adhesive dots. Instead, the air is gradually expelled from the space between circuit board 1 and circuit component 17 from inside to outside, and the contact area 2 is completely wetted with adhesive.

The additional adhesive dots 15 in the corners also merge soon with the corner dots of the regular pattern adjacent to them and finally fill the corners of the contact area up to its outermost tips. Finally, as shown in Fig. 3D, a continuous, void-free adhesive layer 23 is obtained, which extends over the entire contact area 2 and projects slightly beyond the edges thereof, the amount of projection being controllable by metering of the applied amount of adhesive and by the thickness of the adhesive layer, i. e. by the limit of force up to which the circuit board 1 and the circuit component 17 may be pressed against each other.

## Claims

1. A method for gluing a circuit component (17) to a circuit board (1), wherein in a contact area (2) between the circuit component (17) and the circuit board (1), adhesive dots (4) are placed in a regular pattern and are brought to merge by pressing the circuit component (17) and the circuit board (1) against each other, **characterized in that** before placing the dots (4) of the regular pattern, at least one fore-running adhesive dot (14) is placed inside the contact area (2).

2. The method of claim 1, **characterized in that** several fore-running adhesive dots (14) are placed along a line (21).

3. The method of one of the preceding claims, **characterized in that** the amount of adhesive contained in the fore-running adhesive dots (14) is less than a tenth of the amount of adhesive contained in the adhesive dots (4) of the regular pattern.

4. The method for gluing a circuit component (17) to a circuit board (1), wherein in a contact area (2) between the circuit component (17) and the circuit board (1), adhesive dots (13) are placed in a regular pattern and are brought to merge by pressing the circuit component (17) and the circuit board (1) against each other, according to one of the preceding claims, **characterized in that** an additional adhesive dot (15) is placed adjacent to a corner of the regular pattern.

5. The method of claim 4, **characterized in that** the corner of regular pattern corresponds to a corner of the circuit component (17), and that the additional adhesive dot (15) is placed on a bisectrix of the corner of the circuit component (17).

6. The method of claim 4 or 5, **characterized in that** the distance of the additional adhesive dot (15) from an adjacent edge of the circuit component (17) is made smaller than the distance of the dots (4) of the regular pattern from that edge.

7. The method of one of the preceding claims, **characterized in that** the amount of adhesive contained in the adhesive dots (4) of the regular pattern is set for a thickness of the adhesive layer (22) between the circuit board (1) and the circuit component (17) of approx. 2 to 10 µm, preferably approx. 5 µm.

8. The method of one of the preceding claims, **characterized in that** an epoxy resin loaded with metal particles is used as the adhesive.

9. The method of one of the preceding claims, **characterized in that** the adhesive dots (4) are placed using a nozzle (11) through which the adhesive flows.

## Patentansprüche

1. Verfahren zum Ankleben einer Schaltungskomponente (17) an eine Leiterplatte (1), bei dem in einer Kontaktfläche (2) zwischen der Schaltungskomponente (17) und der Leiterplatte (1) Klebstoffpunkte (4) in einem regelmäßigen Muster platziert und dazu gebracht werden, sich zu verbinden, indem die Schaltungskomponente (17) und die Leiterplatte (1) gegeneinander gedrückt werden, **dadurch gekennzeichnet, dass** vor dem Platzieren der Punkte (4) des regelmäßigen Musters mindestens ein Vorlaufklebstoffpunkt (14) in der Kontaktfläche (2) platziert wird.

2. Verfahren nach Anspruch 1, **dadurch gekennzeichnet, dass** mehrere Vorlaufklebstoffpunkte (14) längs einer Linie (21) platziert werden.

3. Verfahren nach einem der vorhergehenden Ansprüche, **dadurch gekennzeichnet, dass** die Klebstoffmenge, die in den Vorlaufklebstoffpunkten (14) enthalten ist, weniger als ein Zehntel der Klebstoffmenge, die in den Klebstoffpunkten (4) des regelmäßigen Musters enthalten ist, ausmacht.

4. Verfahren zum Ankleben einer Schaltungskomponente (17) an eine Leiterplatte (1), bei dem in einer Kontaktfläche (2) zwischen der Schaltungskomponente (17) und der Leiterplatte (1) Klebstoffpunkte (13) in einem regelmäßigen Muster platziert und dazu gebracht werden, sich zu verbinden, indem die Schaltungskomponente (17) und die Leiterplatte (1) gegeneinander gedrückt werden, nach einem der vorhergehenden Ansprüche, **dadurch gekennzeichnet, dass** ein zusätzlicher Klebstoffpunkt (15) angrenzend zu einer Ecke des regelmäßigen Musters platziert wird.

5. Verfahren nach Anspruch 4, **dadurch gekennzeichnet, dass** die Ecke des regelmäßigen Musters einer Ecke der Schaltungskomponente (17) entspricht und dass der zusätzliche Klebstoffpunkt (15) an einer Halbierenden der Ecke der Schaltungskomponente (17) platziert wird.

6. Verfahren nach Anspruch 4 oder 5, **dadurch gekennzeichnet, dass** der Abstand des zusätzlichen Klebstoffpunkts (15) von einer angrenzenden Ecke der Schaltungskomponente (17) kleiner gemacht wird als der Abstand der Punkte (4) des regelmäßigen Musters von dieser Ecke.

7. Verfahren nach einem der vorhergehenden Ansprüche, **dadurch gekennzeichnet, dass** die Klebstoffmenge, die in den Klebstoffpunkten (4) des regelmäßigen Musters enthalten ist, auf eine Dicke der Klebstoffschicht (22) zwischen der Leiterplatte (1) und der Schaltungskomponente (17) von ungefähr 2 bis 10 µm, vorzugsweise ungefähr 5 µm eingestellt wird.

8. Verfahren nach einem der vorhergehenden Ansprüche, **dadurch gekennzeichnet, dass** ein mit Metallteilchen gefülltes Epoxidharz als der Klebstoff verwendet wird.

9. Verfahren nach einem der vorhergehenden Ansprüche, **dadurch gekennzeichnet, dass** die Klebstoffpunkte (4) unter Verwendung einer Düse (11), durch die der Klebstoff fließt, platziert werden.

## Revendications

1. Procédé permettant de coller un composant de circuit (17) sur une carte à circuit (1), moyennant quoi dans une zone de contact (2) entre le composant de circuit (17) et la carte à circuit (1), des points adhésifs (4) sont placés en une configuration régulière et sont amenés à fusionner en pressant le composant de circuit (17) et la carte à circuit (1) l'un contre l'autre, **caractérisé en ce que** avant de placer les points (4) de la configuration régulière, au moins un point adhésif précurseur (14) est placé à l'intérieur de la zone de contact (2).

2. Procédé de la revendication 1, **caractérisé en ce que** plusieurs points adhésifs précurseurs (14) sont placés le long d'une ligne (21).

3. Procédé selon une des revendications précédentes, **caractérisé en ce que** la quantité de colle contenue dans les points adhésifs précurseurs (14) est inférieure à un dixième de la quantité de colle contenue dans les points adhésifs (4) de la configuration régulière.

4. Procédé permettant de coller un composant de circuit (17) sur une carte à circuit (1), moyennant quoi dans une zone de contact (2) entre le composant de circuit (17) et la carte à circuit (1), des points adhésifs (13) sont placés en une configuration régulière et sont amenés à fusionner en pressant le composant de circuit (17) et la carte à circuit (1) l'un contre l'autre, selon une des revendications précédentes, **caractérisé en ce que** un point adhésif additionnel (15) est placé à côté d'un coin de la configuration régulière.

5. Procédé de la revendication 4, **caractérisé en ce que** le coin de la configuration régulière correspond à un coin du composant de circuit (17) et **en ce que** le point adhésif additionnel (15) est placé sur une bissectrice du coin du composant de circuit (17).

6. Procédé de la revendication 4 ou 5, **caractérisé en ce que** la distance du point adhésif additionnel (15) par rapport à un bord adjacent du composant de circuit (17) est rendue plus petite que la distance des points (4) de la configuration régulière par rapport à ce bord.

7. Procédé selon une des revendications précédentes, **caractérisé en ce que** la quantité de colle contenue dans les points adhésifs (4) de la configuration régulière est déterminée pour une épaisseur de la couche adhésive (22) entre la carte de circuit (1) et le composant de circuit (17) d'approximativement 2 à 10 µm, de préférence approximativement 5 µm.

8. Procédé selon une des revendications précédentes, **caractérisé en ce que** une résine époxy chargée de particules métalliques est utilisée comme colle.

9. Procédé selon une des revendications précédentes, **caractérisé en ce que** les points adhésifs (4) sont placés en utilisant une buse (11) à travers laquelle la colle s'écoule.
